# EUROPÄISCHE PATENTANMELDUNG

(11) **EP 1 091 391 A1**
(43) Veröffentlichungstag der Anmeldung: **11.04.2001**
(21) Anmeldenummer: 99890317.3
(22) Anmeldetag: 05.10.1999
(51) Int. Cl.: H01L 21/00, F27D 5/00

(54) **Haltevorrichtung für Halbleiterscheiben**

(71) Anmelder: SICO Produktions- und Handelsges.m.b.H., 9530 Bad Bleiberg (Steiermark) (AT)
(72) Erfinder: Nadrag, Walter, 9530 Bad Bleiberg (AT); Sivec, Klaus, 9500 Villach (AT)
(74) Vertreter: Beer, Manfred, Dipl.-Ing.

(57) **Zusammenfassung**

Eine Haltevorrichtung für Halbleiterscheiben (Wafer), in die mehrere Halbleiterscheiben zueinander parallel und mit Abstand voneinander übereinander eingesetzt werden können, besitzt mehrere in der Gebrauchslage lotrechte Streben (1), an denen mit Abstand übereinander und zueinander parallel Ringe oder Ringsegmente (2) angeordnet sind. Die nach oben weisenden Flächen der Ringe oder Ringsegmente (2), welche die Auflagen für Halbleiterscheiben bilden, sind entweder poliert oder mit Auflagestiften (20) bestückt.

## Beschreibung

Die Erfindung betrifft eine Haltevorrichtung für Halbleiterscheiben, in der mit Abständen übereinander mehrere Halbleiterscheiben angeordnet werden können.

Derartige (vertikale) Haltevorrichtungen für Halbleiterscheiben (Wafer), die auch "Wafer-Boote" genannt werden, besitzen in Verbindungsstreben, die sich zwischen einer Grundplatte und einer Deckplatte erstrecken, eingearbeitete Schlitze, in welche Halbleiterscheiben eingeschoben werden können. Diese Schlitze in den vertikalen Streben weisen rauhe Oberflächen auf, da ein Polieren der Auflageflächen in den Schlitzen mit vertretbarem Aufwand nicht durchführbar ist.

Die bekannten "Wafer-Boote" haben den Nachteil, daß beim Behandeln von Halbleiterscheiben mit einem Prozeßgas der in den Schlitzen der Verbindungsstreben aufgenommene Bereich des Randes von Halbleiterscheiben vom Prozeßgas weniger gut umspült wird, als der übrige Bereich der Halbleiterscheiben. Ein weiterer Nachteil besteht darin, daß die Flächen von Halbleiterscheiben durch die rauhen Oberflächen der Auflageflächen der Schlitze, in welche die Halbleiterscheiben eingesetzt sind, bei den erhöhten Temperaturen, die beim Behandeln von Halbleiterscheiben angewendet werden, beschädigt werden, da sich (mikroskopisch) kleine Spitzen im Bereich der Schlitze in die Flächen der Halbleiterscheiben eindrücken können.

Alle diese Nachteile haben zur Folge, daß bestimmte Bereiche der Halbleiterscheibe für das Herstellen von Chips nicht geeignet sind, so daß die Chip-Ausbeute verringert ist.

Der Erfindung liegt die Aufgabe zu Grunde, eine Haltevorrichtung für Halbleiterscheiben ("Wafer-Boot") zur Verfügung zu stellen, die einfach aufgebaut ist und die geschilderten Nachteile nicht aufweist.

Gelöst wird diese Aufgabe mit einer Haltevorrichtung, welche die Merkmale des Anspruches 1 aufweist.

Bevorzugte und vorteilhafte Ausgestaltungen der erfindungsgemäßen Haltevorrichtung sind Gegenstand der Unteransprüche.

Dadurch, daß bei der erfindungsgemäßen Haltevorrichtung die Auflagen für die Halbleiterscheibe von Ringen oder Ringsegmenten gebildet werden, ist wenigstens die Oberseite der Halbleiterscheibe für das beim (thermischen) Behandeln von Halbleiterscheiben verwendete Prozeßgas gut zugänglich.

Bevorzugt ist es, daß die Auflageflächen der Ringe oder Ringsegmente, auf welchen die Halbleiterscheiben aufliegen, poliert sind, so daß Abdrücke von Spitzen in den Flächen der Halbleiterscheiben praktisch ausgeschlossen sind.

Wenn auch die Unterseite von Halbleiterscheiben zu behandeln ist, also von einem Prozeßgas gut umspült werden soll, wenn (thermische) Behandlungsprozesse ausgeführt werden, können auf den Ringen oder Ringsegmenten, gegebenenfalls zugespitzte, Stifte angeordnet sein, so daß die Halbleiterscheiben im wesentlichen nur punktförmig aufliegen

In jedem Fall wird bei Verwendung der erfindungsgemäßen Haltevorrichtung wegen der kleinen Berührungsgsflächen zwischen Haltevorrichtung und Halbleiterscheiben ein gutes Umspülen von Halbleiterscheiben mit Prozeßgas erreicht.

Ein Nachteil bekannter Halbleitervorrichtungen besteht auch darin, daß es zwischen dem Werkstoff der Streben der Haltevorrichtung und dem Werkstoff der Halbleiterscheibe zu Diffusionen kommt, so daß die Halbleiterscheibe durch das Eindiffudieren von Werkstoff aus der Haltevorrichtung in die Halbleiterscheibe, an dieser Stelle in ihrer Zusammensetzung nachteilig verändert wird. Die der bei der erfindungsgemäßen Haltevorrichtung an sich schon geringen Diffussion zwischen Haltevorrichtung und Halbleiterscheiben kann erfindungsgemäß praktisch völlig unterbunden werden, wenn gemäß einer Ausführungsform der Erfindung vorgesehen ist, daß die Ringe oder Ringsegmente aus dem gleichen Werkstoff wie die zu haltende Halbleiterscheibe, vorzugsweise Silizium, bestehen. Die ist bei der Erfindung möglich, weil die Ringe oder Ringsegmente ohne weiteres aus dem Werkstoff hergestellt werden können, aus dem Halbleiterscheiben bestehen.

Weitere Merkmale und Vorteile sowie Einzelheiten der Erfindung ergeben sich aus der nachstehenden Beschreibung bevorzugter Ausführungsbeispiele der erfindungsgemäßen Haltevorrichtung (Wafer-Boot) anhand der Zeichnungen.

Es zeigt:
Fig. 1 in schematischer Darstellung eine erste Ausführungsform einer Haltevorrichtung, wobei nur einige der Ringsemente gezeigt sind,
Fig. 2 ein Ringsegment der Haltevorrichtung von Fig. 1,
Fig. 3 einen Teil der Haltevorrichtung von Fig. 1 in vergrößertem Maßstab,
Fig. 4 eine erfindungsgemäße Haltevorrichtung mit Ringen,
Fig. 5 einen Ring der Haltevorrichtung von Fig. 4,
Fig. 6 einen Auflagestift,
Fig. 7 eine andere Ausführungsform eines Auflagestiftes und
Fig. 8 bis 10 verschiedene Querschnittsformen von Ringen oder Ringsegmenten.

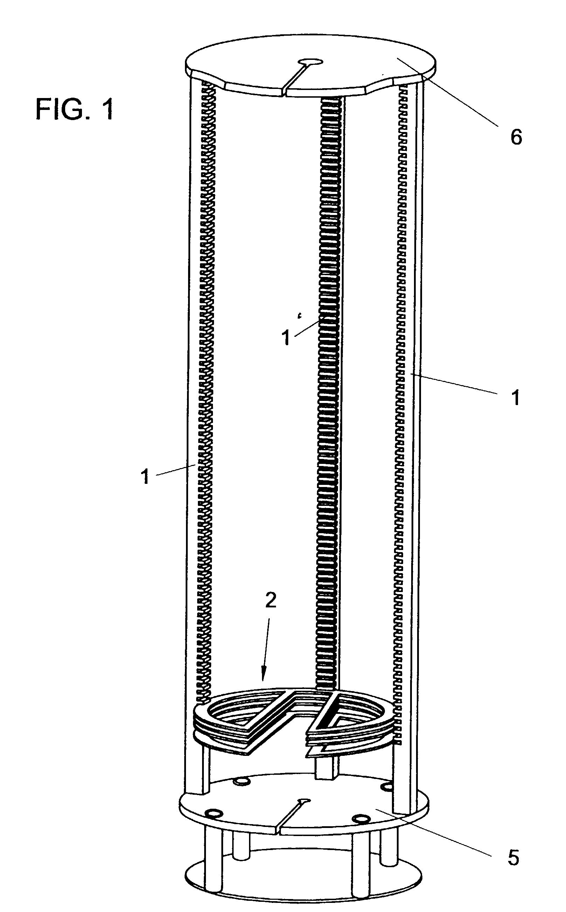

Bei dem in Fig. 1 gezeigten Ausführungsbeispiel besteht die Haltevorrichtung aus mehreren, im gezeigten Beispiel drei, lotrechten Streben 1, an denen Ringsegmente 2 gehalten sind. Die Ringsegmente 2 sind mit Abstand übereinander und zueinander parallel angeordnet und bilden Auflagen für Halbleiterscheiben (Wafer). Die Streben 2 sind an ihren Enden auf nicht gezeigte Art und Weise mit Endscheiben 5 und 6 verbunden.

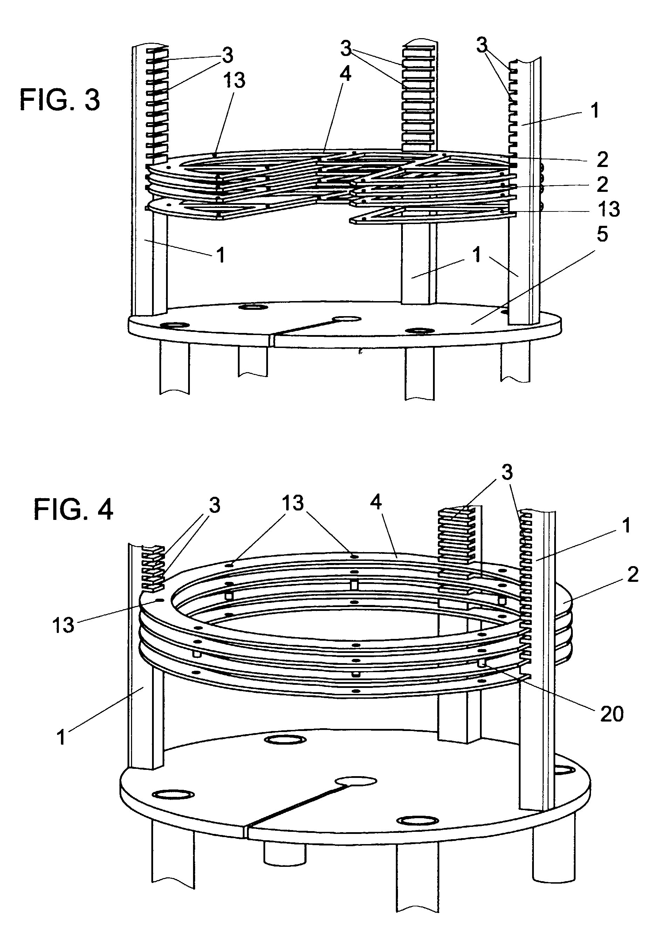

Wie in Fig. 3 gezeigt, sind die Ringsegmente 2 in nach innen offene Schlitze 3 in den Streben 1 eingesetzt und in diesen gegebenenfalls befestigt.

Die Auflageflächen 4 der Ringsegmente 2, auf welchen die Halbleiterscheiben aufliegen, sind poliert. Das Polieren dieser Auflageflächen 4 ist ohne weiteres möglich, da diese gut zugänglich sind.

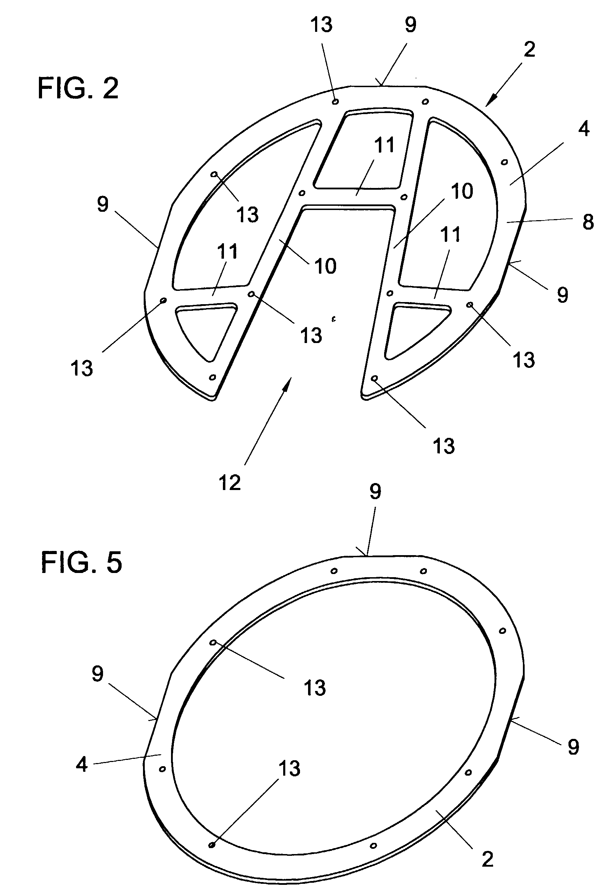

Wie in Fig. 2 gezeigt bestehen die Ringsegmente 2 aus einem teilkreisringförmigen Ringteil 8 mit abgeflachten Randbereichen 9, mit denen das Ringsegment 2 in die Schlitze 3 der Streben 1 eingesetzt ist. Innerhalb des Ringteils 8 sind Stege 10 und Querstege 11 angeordnet. Die Stege 10 gehen von den neben dem offenen Teil 12 liegenden Enden des Ringteils 8 aus und verlaufen annähernd diametral durch den vom Ringteil 8 umgrenzten Bereich. So kann durch den offenen Teil 12 ein Löffel oder ein Greifer zum Auflegen einer Halbleiterscheibe auf das Ringsegment 2 eingeführt werden. Dennoch ist die Halbleiterscheibe nicht nur an ihrem Rand sondern auch in ihrem Mittelteil von unten her durch die Stege 10 und die Querstege 11 abgestützt und kann sich auch bei hohen Behandlungstemperaturen nicht biegen.

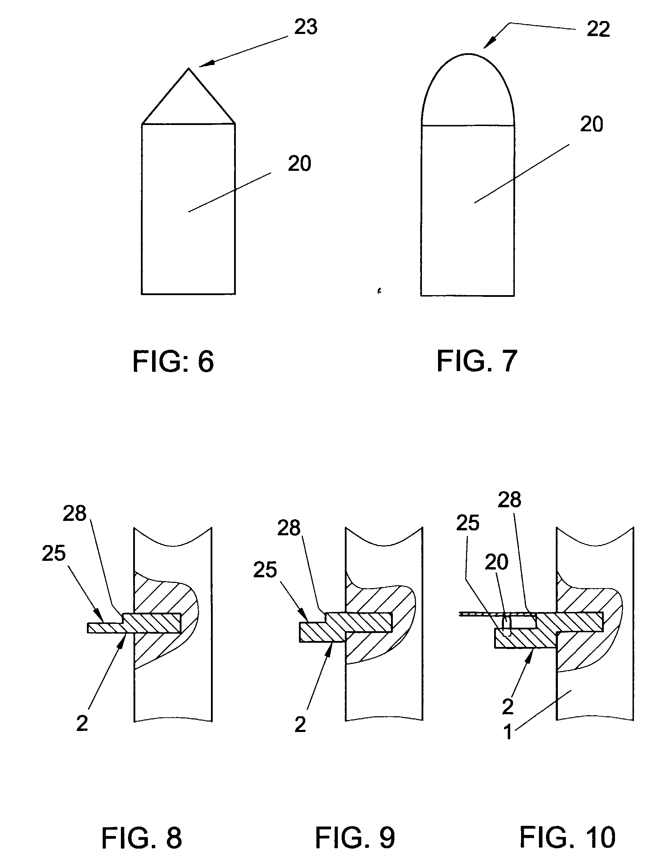

Im Ringteil 8, in den Stegen 10 und gegebenenfalls in den Querstegen 11 können Bohrungen 13 vorgesehen sein, in die Auflagestifte 20 (Fig. 6, 7) eingesetzt werden können, welche die Halbleiterscheibe im Abstand über dem Ringsegment 2 halten.

Bei der in Fig. 4 gezeigten Ausführungsform einer Haltevorrichtung sind in die Schlitze 3 in den Streben 1 Ringe 2 eingesetzt, die gegebenenfalls mit nach oben weisenden Auflagestiften 20 (nur einige sind gezeigt) ausgestattet sind. Wie in Fig. 4 gezeigt wird, sind auch bei dieser Ausführungsform mit Abstand übereinander und zueinander parallel an den Streben 1 mehrere Ringe 2 angeordnet.

Die in die Ringe bzw. Ringsegmente 2 eingesetzten Stifte 20 können, so wie in Fig. 7 gezeigt, ein halbkugelförmiges, nach oben weisendes Ende 22 haben, oder, sie weisen wie in Fig. 6 gezeigt ist, eine kegelförmige Spitze 23 auf. Um die Auflagefläche zwischen Halbleiterscheibe und Stift 20 klein zu halten, können die Stifte 20 an ihren oberen Enden auch kegelstumpfförmig oder pyramidenstumpfförmig ausgebildet sein. Auch pyramidenförmige Spitzen an den nach oben weisenden Enden der Stifte 20 sind denkbar. Wenn in den Ringen bzw. Ringsegmenten 2 Stifte 20 vorgesehen sind, brauchen die nach oben weisenden Flächen der Ringe oder Ringsegmente 2 selbst nicht poliert sein. Es genügt, wenn gemäß einer bevorzugten Ausführungsform die Bereiche der Stifte 20, auf welchen eine Halbleiterscheibe aufliegt, poliert sind.

Die Ringe oder Ringsegmente 2 können, ganz gleich ob Auflagestifte 20 vorgesehen sind oder nicht, eine gekröpfte Querschnittsform Fig. 9, 10) besitzen. Auch im Querschnitt gestufte Ringe oder Ringsegmente 2, sind denkbar (Fig. 8), wobei Stifte 20 von der Stufenfläche 25 nach oben abstehen können. Wenn die Ringe oder Ringsegmente 2 eine gekröpfte (Fig. 9, 10) oder gestufte (Fig. 8) Querschnittsform besitzen - im Ergebnis sind bei beiden Ausführungsformen der Ringe oder Ringsegmente 2 am Rand der Auflagefläche 4 nach oben abstehende, im wesentlichen lotrechte Flächen 28 vorgesehen - ist ein seitliches Verrutschen oder Verschieben von Halbleiterscheiben, die auf den Ringen oder Ringsegmenten 2 aufliegen, verhindert und ein sicherer Halt der Halbleiterscheiben gewährleistet, da die Halbleiterscheiben (siehe Fig. 10) mit ihrem Umfangsrand an den im wesentlichen lotrechten Flächen 28 der Ringe oder Ringsegmente 2 anliegen können.

Bevorzugt ist es, wenn die Ringe oder Ringsegmente 2 und die gegebenenfalls vorgesehenen Stifte 20 aus dem gleichen Werkstoff (meist Silizium) bestehen wie die zu behandelnden Halbleiterscheiben, so daß nachteiliges Eindiffundieren von Fremdstoffen in die Halbleiterscheiben verhindert wird.

Zusammenfassend kann ein bevorzugtes Ausführungsbeispiel der Erfindung wie folgt beschrieben werden:

Eine Haltevorrichtung für Halbleiterscheiben (Wafer), in die mehrere Halbleiterscheiben zueinander parallel und mit Abstand voneinander übereinander eingesetzt werden können, besitzt mehrere in der Gebrauchslage lotrechte Streben 1, an denen mit Abstand übereinander und zueinander parallel Ringe oder Ringsegmente 2 angeordnet sind. Die nach oben weisenden Flächen 4 der Ringe oder Ringsegmente 2, welche die Auflagen für Halbleiterscheiben bilden, sind entweder poliert oder mit Auflagestiften 20 bestückt.

## Patentansprüche

1. Haltevorrichtung für Halbleiterscheiben (Wafer), in der mehrere Halbleiterscheiben mit Abstand übereinander und zueinander parallel angeordnet werden können, mit lotrechten Streben (1), an denen Auflagen für Halbleiterscheiben vorgesehen sind, dadurch gekennzeichnet, daß die Auflagen für die Halbleiterscheiben Ringe oder Ringsegmente (2) sind, die an den lotrechten Streben (1) angebracht sind.

2. Vorrichtung nach Anspruch 1, dadurch gekennzeichnet, daß die Ringe oder Ringsegmente (2) in Aussparungen (3) in den Streben (1) eingesetzt sind.

3. Vorrichtung nach Anspruch 1 oder 2, dadurch gekennzeichnet, daß die Ringe oder Ringsegmente (2) eine rechteckige Querschnittsform besitzen.

4. Vorrichtung nach Anspruch 1 oder 2, dadurch gekennzeichnet, daß die Ringe oder Ringsegmente (2) eine gekröpfte Querschnittsform besitzen.

5. Vorrichtung nach Anspruch 1 oder 2, dadurch gekennzeichnet, daß die Ringe oder Ringsegmente (2) eine gestufte Querschnittsform besitzen.

6. Vorrichtung nach einem der Ansprüche 1 bis 5, dadurch gekennzeichnet, daß die nach oben weisenden Flächen (4), der Ringe oder Ringsegmente (2) auf welchen Halbleiterscheiben aufzulegen sind, poliert sind.

7. Vorrichtung nach einem der Ansprüche 1 bis 6, dadurch gekennzeichnet, daß von den nach oben weisenden Flächen (4) der Ringe oder Ringsegmente (2) Auflagestifte (20) abstehen.

8. Vorrichtung nach Anspruch 7, dadurch gekennzeichnet, daß die oberen Enden (22, 23) der Stifte (6), auf welchen Halbleiterscheiben aufzulegen sind, poliert sind.

9. Vorrichtung nach Anspruch 7 oder 8, dadurch gekennzeichnet, daß die oberen Enden der Stifte (20) halbkugelförmig, kegelförmig, kegelstumpfförmig, pyramidenförmig oder pyramidenstumpfförmig sind.

10. Vorrichtung nach einem der Ansprüche 1 bis 9, dadurch gekennzeichnet, daß der Außenrand der Ringe oder Ringsegmente (2) in den Bereichen (9), in denen sie in Schlitze (3) in den Streben (1) eingesetzt sind, abgeflacht ist.

11. Vorrichtung nach einem der Ansprüche 7 bis 10, dadurch gekennzeichnet, daß in den Ringen oder Ringsegmenten (2) Löcher (13) für die Aufnahme von Auflagestiften (20) vorgesehen sind.

12. Vorrichtung nach einem der Ansprüche 1 bis 11, dadurch gekennzeichnet, daß jedes Ringsegment (2) einen teilringförmigen Ringteil (8) mit einer Unterbrechung (12) und innerhalb eines Ringteils (8) Streben (10) und Querstreben (11) aufweist.

13. Vorrichtung nach Anspruch 12, dadurch gekennzeichnet, daß die Streben (10) von den neben der Unterbrechung (12) im Ringteil (8) liegenden Enden desselben ausgehend etwa diamentral zum gegenüberliegenden Bereich des Ringteils (8) verlaufen.

14. Vorrichtung nach einem Ansprüche 1 bis 13, dadurch gekennzeichnet, daß die Ringe oder Ringsegmente (2) aus dem gleichen Werkstoff wie die zu haltende Halbleiterscheibe, vorzugsweise aus Silizium, bestehen.
